# FASCICULE DE BREVET EUROPEEN

(11) **EP 2 098 607 B1**
(45) Date de publication et mention de la délivrance du brevet: **22.06.2011**
(21) Numéro de dépôt: 08290173.7
(22) Date de dépôt: 25.02.2008
(51) Int. Cl.: C23C 14/02, C23C 14/06, C23C 14/58, C23C 2/06, C23C 2/26, C23C 2/28, C23C 28/02

(54) **Procédé de revêtement d'une bande métallique et installation de mise en oeuvre du procédé**
Beschichtungsverfahren eines Metallstreifens und Anlage zur Ausführung dieses Verfahrens
Method of coating a metal strip and installation for implementing the method

(43) Date de publication de la demande: 09.09.2009
(73) Titulaire: ArcelorMittal France, 93200 Saint Denis (FR)
(72) Inventeur: Vanhee, Luc, 08600 Fromelennes (FR); Deweer, Benoit, 1933 Sterrebeek (BE); Silberberg, Eric, 5340 Haltinne (Gesves) (BE)
(74) Mandataire: Plaisant, Sophie Marie

(56) Documents cités:
- EP-A- 1 518 941
- EP-A- 1 743 956
- EP-A- 1 767 670
- WO-A-02/14573
- WO-A-2006/045570
- WO-A-2007/135092
- SCHUHMACHER B ET AL: "Novel coating systems based on PVD for steel sheet" VAKUUM IN FORSCHUNG UND PRAXIS, WILEY-VCH, WEINHEIM, DE, vol. 13, no. 4, 1 août 2001 (2001-08-01), pages 233-235, XP002389830 ISSN: 0947-076X

## Description

La présente invention concerne un procédé de revêtement de bande métallique, plus particulièrement destiné au revêtement de bandes d'acier par des couches à base de zinc et d'éléments métalliques oxydables, sans pour autant y être limitée.

On connaît différents procédés permettant de déposer sur une surface métallique, telle qu'une bande d'acier, des revêtements métalliques composés d'une couche de métal, de plusieurs couches successives de différents métaux, ou bien encore d'alliages métalliques. Parmi celles-ci, on pourra citer la galvanisation au trempé à chaud, l'électrodéposition ou bien encore les différents procédés de dépôt sous vide (évaporation, sputtering magnétron).

Certains produits doivent se déposer en plusieurs couches pour des raisons technologiques, voire économiques, et subir un traitement thermique de diffusion donnant accès à l'alliage dont les propriétés sont celles recherchées. Cela peut par exemple être le cas des dépôts de zinc-magnésium qui peuvent avantageusement remplacer les dépôts de zinc pur ou d'autres alliages de zinc.

Le traitement thermique de diffusion peut s'avérer complexe et onéreux. Il peut impliquer l'utilisation de grandes quantités de gaz d'inertage pour prévenir des oxydations favorisées par les hautes températures, lors du traitement thermique. En outre, afin d'éviter tout risque d'oxydation entre le dépôt de l'élément oxydable et son traitement de diffusion, il est nécessaire ou conseillé de pratiquer les deux opérations immédiatement à la suite l'une de l'autre, sans exposer la bande à l'air libre.

Par ailleurs, une ligne de traitement de surface en continu a généralement des vitesses de procédés incompatibles avec les temps nécessaires à la diffusion. Il s'ensuit alors deux possibilités.

La première consiste à réaliser des équipements de traitement en continu à température modérée, dont la taille permette d'assurer les temps nécessaires à la diffusion, mais ceux-ci sont alors encombrants, coûteux et on ne dispose pas toujours de la place nécessaire à leur implantation. Ainsi, des essais ont montré qu'à 300°C, pour un dépôt de zinc surmonté d'une couche de magnésium présentant une épaisseur de 1,5 µm, il faut 50 secondes pour accomplir la diffusion, ce qui représente une distance de 150 m de maintien à température pour une bande défilant à 180 m/min.

Dans l'exemple d'une ligne d'électrozingage travaillant à2,5 m/s et le cas d'un alliage de zinc et de magnésium ayant 1 µm d'épaisseur, le traitement thermique en continu à basse température (de l'ordre de 150°C) n'est pas envisageable, car les temps de diffusions seraient supérieurs à plusieurs heures. De tels temps sont difficilement acceptables et imposent donc dans la pratique industrielle d'envisager de plus hautes températures.

La seconde solution consiste à réaliser des équipements de traitement en continu plus courts en augmentant les vitesses de diffusion par l'utilisation de températures plus élevées. Ainsi, pour un dépôt de zinc surmonté d'une couche de magnésium présentant une épaisseur de 1,5 µm, il est possible de limiter la diffusion à plus ou moins 10 secondes, ce qui représente une distance de 30 m de maintien à température pour une bande défilant à 180 m/min. Cependant, la fenêtre de travail pour ce type de traitement dynamique de diffusion est très réduite, car dès que l'on atteint 350 à 360°C, le dépôt fond en passant par un eutectique et mène à une altération des propriétés du revêtement. La mise en oeuvre du procédé sur des lignes de forte capacité dont la vitesse de défilement de la bande est de 160 à 180 m/min est donc très délicate. En outre, les énergies à mettre en oeuvre sont plus importantes et on s'interdit le traitement de certaines nuances d'acier, telles les nuances dites à bake-hardening, massivement utilisées dans l'automobile.

Par ailleurs, même en réduisant la taille des équipements, les longueurs de traitement à mettre en oeuvre restent telles que l'équipement de traitement en continu doit prévoir des rouleaux support de bande ou déflecteurs de celle-ci, qui sont complexes et onéreux, car ils doivent être refroidis et conçus de manière à ne pas perturber la couche formée, ce qui peut notamment arriver par collage des bandes sur ses rouleaux.

Le but de la présente invention est donc de remédier aux inconvénients des procédés de l'art antérieur en mettant à disposition un procédé de fabrication d'une bande métallique recouverte d'un revêtement monocouche ou bicouche à base de zinc ou d'alliage de zinc et d'un métal ou d'un alliage métallique oxydable, qui consomme peu d'énergie et de gaz d'inertage, qui soit facile à mettre en oeuvre, qui soit d'un faible encombrement et permette le traitement de substrats métalliques de nature variée.

A cet effet, un premier objet de la présente invention est constitué par un procédé de revêtement d'une bande métallique selon lequel on dépose sous vide une couche de métal oxydable ou d'alliage métallique oxydable sur une bande métallique préalablement revêtue de zinc ou d'alliage de zinc, puis on bobine la bande métallique revêtue et on procède à un traitement statique de diffusion de la bobine enroulée, sous atmosphère non-oxydante, afin d'obtenir une bande dont le revêtement comprend, en partie supérieure, une couche d'alliage formé par diffusion du métal oxydable ou de l'alliage métallique oxydable dans tout ou partie de la couche de zinc ou d'alliage de zinc.

Le procédé selon l'invention peut également comprendre différentes caractéristiques optionnelles, prises seules ou en combinaison :
- le revêtement comprend uniquement une couche d'alliage formé par diffusion du métal oxydable ou de l'alliage métallique oxydable dans toute la couche de zinc ou d'alliage de zinc,
- le revêtement comprend une partie inférieure constituée de zinc ou d'alliage de zinc et une partie supérieure constituée d'une couche d'alliage formé par diffusion du métal oxydable ou de l'alliage métallique oxydable dans une partie de la couche de zinc ou d'alliage de zinc.

- la bande métallique a été préalablement revêtue de zinc ou d'alliage de zinc par un procédé de galvanisation au trempé à chaud,
- la bande métallique a été préalablement revêtue de zinc ou d'alliage de zinc par un procédé d'électrodéposition,
- la bande métallique a été préalablement revêtue de zinc ou d'alliage de zinc par un procédé de dépôt sous vide, ou par tout autre technique de dépôt,
- la bande métallique revêtue de zinc ou d'alliage de zinc est revêtue de magnésium ou d'alliage de magnésium par dépôt sous vide,
- la bande métallique est préalablement revêtue d'une couche de zinc ou d'alliage de zinc présentant une épaisseur comprise entre 0,5 et 15 µm, de préférence entre 0,5 et 7,5 µm, de façon plus particulièrement préférée entre 0,5 et 5 µm,
- on dépose une couche de magnésium par évaporation sous vide en une épaisseur comprise entre 0,2 et 5 µm, de préférence entre 0,2 et 2 µm,
- on forme, lors du recuit statique de diffusion, une couche d'alliage de composition Zn₂Mg, comprenant éventuellement des composés Zn₁₁Mg₂,
- le revêtement de la bande métallique revêtue du métal ou de l'alliage métallique oxydable est oxydé en surface avant de subir ledit traitement statique de diffusion.
- la bobine de bande métallique est chauffée pendant une durée comprise entre 4 et 40 heures, à une température inférieure à 200°C,
- la bande métallique est une bande d'acier, et peut être en acier à durcissement par cuisson (bake-hardening).

Un second objet de l'invention est constitué par une installation pour la mise en oeuvre du procédé selon l'invention, comprenant :
- un dispositif de galvanisation de ladite bande métallique, suivi par
- un dispositif de revêtement par dépôt sous vide, et
- un dispositif de traitement thermique statique sous atmosphère contrôlée.

L'installation selon l'invention peut également comprendre les variantes suivantes, prises isolément ou en combinaison :
- le dispositif de galvanisation est un dispositif de galvanisation au trempé à chaud,
- le dispositif de galvanisation est un dispositif de galvanisation par électrodéposition,
- le dispositif de galvanisation est un dispositif de galvanisation par dépôt sous vide.

D'autres caractéristiques et avantages de l'invention apparaîtront à la lecture de la description qui va suivre, donnée uniquement à titre d'exemple.

Le procédé selon l'invention s'applique plus particulièrement, mais pas uniquement, au traitement de bandes d'acier, revêtues de zinc ou d'alliage de zinc. Par alliage de zinc, on désigne tout composé comprenant au moins 50% de zinc et pouvant contenir, par exemple, de l'aluminium, du fer, du silicium etc...

L'obtention des bandes revêtues pourra être fait par tout procédé connu de galvanisation, qu'il s'agisse de galvanisation au trempé à chaud, d'électrodéposition ou de dépôt par évaporation sous vide, par exemple. On préfèrera cependant les bandes revêtues par électrodéposition ou dépôt par évaporation sous vide qui présentent une épaisseur de dépôt constante sur toute la surface de la bobine d'acier.

L'épaisseur du revêtement sera de préférence comprise entre 0,5 et 15 µm. En effet, en dessous de 0,5 µm, la protection contre la corrosion de la bande risquerait d'être insuffisante. L'épaisseur du revêtement peut atteindre 15 µm en fonction des applications finales de la bande, mais est en général inférieure à 7,5 µm, car il n'est pas nécessaire d'aller au-delà pour avoir le niveau de résistance à la corrosion requis dans l'automobile, notamment.

On pourra bien sur employer le procédé selon l'invention à tout substrat métallique revêtu susceptible de ne pas voir ses propriétés détériorées de façon irréversible lors du traitement thermique ultérieur. Ainsi, on pourra notamment appliquer le procédé selon l'invention à des bandes d'acier dits à bake-hardening qui contiennent de fortes quantités de carbone en solution solide, qui ne doit pas être totalement précipité avant que la bande soit mise en forme par emboutissage ou tout autre procédé adapté. Le traitement thermique selon l'invention, malgré ses faibles niveaux de température va précipiter une petite partie du carbone en solution solide présent dans ces nuances, mais un traitement d'écrouissage superficiel après diffusion permettra de restaurer les propriétés de ces nuances, ce qui ne serait pas possible avec les procédés de l'art antérieur. La réalisation du cycle de recuit statique à faible température permet ainsi de rendre compatible le traitement thermique à la plupart des métallurgies.

La bande métallique revêtue de zinc ou d'alliage de zinc, est tout d'abord revêtue d'une couche de métal oxydable ou d'un alliage oxydable par un procédé de dépôt sous vide. On pourra notamment citer les procédés de sputtering magnétron, de dépôt par plasma froid, d'évaporation sous vide, sans pour autant y limiter l'invention.

L'utilisation d'un tel procédé permet notamment de déposer une très fine couche de métal ou d'alliage oxydable, qui sera de préférence comprise entre 0,2 et 5 µm. Dans la plupart des applications, l'épaisseur pourra cependant être limitée à 2 µm, du fait de l'amélioration considérable des propriétés de résistance à la corrosion apportée par la formation de l'alliage. En outre, ce type de procédé de revêtement permet de déposer cette couche supplémentaire sans chauffer la bande et donc sans la soumettre à des phénomènes de diffusion entre le substrat et la couche de zinc.

Le dépôt du métal ou de l'alliage métallique oxydable se fait de façon classique à partir d'une bobine métallique que l'on déroule avant de la faire pénétrer dans l'enceinte de dépôt. La bande défile dans cette enceinte où elle est soumise au dépôt, puis sort de l'enceinte et est bobinée de façon classique là-aussi.

Le métal oxydable peut en particulier être constitué de magnésium, qui présente l'avantage de renforcer fortement la résistance à la corrosion d'une bande métallique lorsqu'il est ajouté au zinc dans le revêtement de surface de cette bande métallique.

A l'issue de cette étape de dépôt, la bande métallique est donc recouverte d'une couche de zinc ou d'alliage de zinc, surmontée d'une couche de métal ou d'alliage oxydable. Le bobinage puis le stockage de la bande étant effectué sans inertage de la bande, celle-ci s'oxyde rapidement en extrême surface au contact de l'oxygène de l'air, formant une couche d'oxydation.

Les présents inventeurs ont alors tenté de procéder à un recuit statique de la bobine métallique non déroulée, qui a permis d'obtenir une diffusion tout à fait correcte de l'élément oxydable dans la couche supérieure de la couche de zinc ou d'alliage de zinc. De façon tout à fait surprenante, la couche d'oxydation n'a en rien gêné cette diffusion, contrairement à ce que l'homme du métier aurait pu attendre.

En outre, cette même couche d'oxydation s'est avérée propice au non collage des spires de la bobine lors du traitement thermique de diffusion.

Il reste bien sûr possible de protéger la bande métallique de l'oxydation durant le transport et le stockage entre l'opération de revêtement et le traitement thermique par la réalisation d'un ultime dépôt de protection. Mais les essais réalisés en laboratoire montrent que cette protection n'est pas nécessaire.

Le recuit statique est effectué dans une installation classique de recuit base sous une atmosphère non-oxydante.

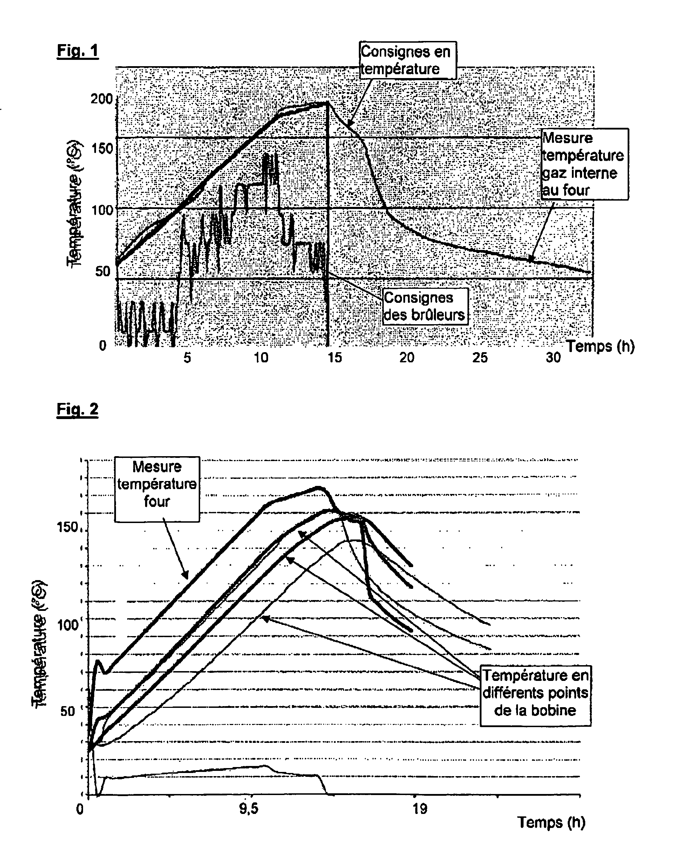

Comme dans le cas d'un recuit métallurgique de bobine métallique non revêtue, les vitesses de montée et de descente en température doivent être adaptées en fonction des hétérogénéités de température que l'on accepte au sein de la bobine métallique. Les autres caractéristiques des cycles thermiques à réaliser, telles que la durée de la montée en température, le temps de maintien, la durée du refroidissement, sont également déterminées en fonction du niveau de température maximum souhaité. Ainsi, on peut voir en figure 1 un exemple de cycle thermique réel () pour le traitement d'une bobine d'acier de 2 tonnes. Cette figure représente les consignes en température et le pilotage des bruleurs d'un dispositif de traitement thermique statique. On voit que la montée en température est effectuée sur 14 heures jusqu'à atteindre 170°C, puis le chauffage est interrompu et la bobine refroidit progressivement jusqu'à atteindre 55°C au bout de 30 heures de traitement total.

Ce type de recuit s'effectuant sur des durées allant généralement de 4 à 40 heures, les températures maximum atteintes seront généralement inférieures à 200°C. Ceci permet de traiter un grand nombre de nuances d'acier ou de métal sensibles à une élévation trop importante de la température qui ne pourrait subir un recuit continu. En effet, en raison de la vitesse importante de défilement lors d'un recuit continu, la température du palier est beaucoup plus élevée.

Des cycles de diffusion statique ont été réalisés à différentes températures et différents serrages entre tôles. Ces différents serrages ont montré que, bien au delà de la gamme normale des contraintes d'enroulement et bien au delà de la gamme normale des pressions subies lors des traitements thermiques sur bobines, il n'y avait pas de collage entre spires.

Les tôles issues de ces traitements thermiques de diffusion statique montrent des produits correctement diffusés et l'obtention de l'alliage visé en surface du revêtement, avec diffusion totale ou partielle en fonction des cas.

### Exemple de réalisation

A titre d'exemple, une bobine de 15 tonnes de bande d'acier à bake-hardening revêtue d'une couche de 2,5 µm de zinc par électrodéposition, est ensuite revêtue d'une couche de 1 µm de magnésium par évaporation sous vide. La bande a ensuite séjourné plusieurs jours à l'air libre sans protection particulière, ce qui a entraîné la formation d'une couche d'oxyde de magnésium en extrême surface.

La bande métallique est ensuite soumise à un traitement de recuit statique à 160°C pour faire diffuser le magnésium dans le zinc.

Le gaz d'inertage utilisé pendant le recuit statique est un mélange d'azote et d'hydrogène, identique à celui utilisé classiquement pour le recuit des aciers à bas carbone. On n'observe pas d'oxydation de la bobine métallique lors du traitement thermique du fait de l'utilisation d'un gaz d'inertage non oxydant.

Le cycle thermique subi par la bobine est représenté en figure 2. Cette figure représente en plus de l'évolution de la température du gaz interne au four, les évolutions en température des différents points de la bobine d'acier dont en particulier le point le plus chaud et le point le plus froid.

On voit que la montée en température est réalisée pendant une durée approximative de 14 heures. Le palier de maintien en température à 160°C, qui correspond au temps de diffusion du magnésium s'effectue en environ 2 heures. Le refroidissement jusqu'à la température de 70°C dure 8 heures. Le cycle total est ainsi voisin de 24 heures. Dans la pratique, on obtient un tel palier de refroidissement en éteignant simplement le four et en laissant la bobine à l'intérieur. Pour amorcer le refroidissement, on sort la bobine du four et on la place sous une cloche de refroidissement qui permet de contrôler les conditions de ce refroidissement.

On réalise ainsi l'alliation de la totalité du magnésium avec une partie du zinc formant la première couche et on obtient ainsi un revêtement présentant une sous-couche de zinc et une couche supérieure d'alliage Zn-Mg. Les différences de températures entre le point le plus chaud de la bobine et le point le plus froid de la bobine engendrent une différence de taux de diffusion limitée à quelques pourcents, ce qui n'entraîne pas de modifications significatives des propriétés du revêtement. Il est d'ailleurs possible d'adapter le temps de maintien en température avant refroidissement afin de permettre une homogénéisation complète de ce taux de diffusion si cela s'avérait nécessaire.

L'invention rend possible la réalisation de revêtements comprenant des alliages à partir de dépôts multi-couches, sans avoir à investir dans un complexe et coûteux dispositif de diffusion au défilé. L'espace nécessaire en ligne de revêtement est alors réduit de l'ordre de 50% par rapport à un équipement effectuant le recuit en ligne. L'invention est donc particulièrement adaptée aux nouveaux produits à appliquer sur une ligne de production existante, quand le volume de production est faible ou quand la courbe de démarrage est longue et lente.

L'invention utilise un traitement thermique en statique de temps plus long et à plus basse température de ce qui doit être atteint sur une ligne en continu. L'invention permet l'utilisation d'outils compacts pour réaliser la diffusion. Elle minimise la consommation en gaz d'inertage, elle minimise la consommation en énergie à la tonne (ainsi que la puissance à installer) et abaisse la température du cycle de diffusion rendant le traitement compatible à une large gamme de produits sidérurgiques et nuances d'acier.

L'invention permet d'utiliser les recuits bases ou des outils de production similaires pour réaliser l'alliation nécessaire à la réalisation du produit final. L'utilisation d'outils de recuit base existants permet de réduire le coût d'investissement de l'ordre de 30% (pris sur un investissement incluant le dépôt et le traitement thermique) et rend ainsi la possibilité de décider d'investir et de lancer sur le marché des nouveaux produits à durée de vie plus réduite ou à volume cumulé inférieur.

La combinaison de procédés rend possible la réalisation de revêtements multicouches novateurs. Combinés à un traitement thermique de diffusion, ceux-ci peuvent donner naissance à un alliage conférant au produit revêtu des caractéristiques de surface intéressantes.

Il faut alors soit construire une nouvelle installation de production, soit compléter une installation de production existante. Ce second cas est plus opportun à condition qu'il combine dans l'alliage un métal déjà déposé à l'aide de l'installation existante et que l'installation ait les disponibilités en place et en capacité pour assurer la nouvelle production.

La présente invention vise en particulier à l'obtention de revêtements de zinc-magnésium, mais ne se limite pas à ces revêtements et englobe tout revêtement à base de métal ou d'alliage oxydable.

## Revendications

1. Procédé de revêtement d'une bande métallique selon lequel on dépose sous vide une couche de métal oxydable ou d'alliage métallique oxydable sur une bande métallique préalablement revêtue de zinc ou d'alliage de zinc, puis on bobine la bande métallique revêtue et on procède à un traitement statique de diffusion de la bobine enroulée, sous atmosphère non-oxydante, afin d'obtenir une bande dont le revêtement comprend, en partie supérieure, une couche d'alliage formé par diffusion du métal oxydable ou de l'alliage métallique oxydable dans tout ou partie de la couche de zinc ou d'alliage de zinc.

2. Procédé selon la revendication 1, selon lequel la bande métallique a été préalablement revêtue de zinc ou d'alliage de zinc par un procédé de galvanisation au trempé à chaud.

3. Procédé selon la revendication 1, selon lequel la bande métallique a été préalablement revêtue de zinc ou d'alliage de zinc par un procédé d'électrodéposition.

4. Procédé selon la revendication 1, selon lequel la bande métallique a été préalablement revêtue de zinc ou d'alliage de zinc par un procédé de dépôt sous vide.

5. Procédé selon l'une quelconque des revendications 1 à 4, selon lequel la bande métallique revêtue de zinc ou d'alliage de zinc est revêtue de magnésium ou d'alliage de magnésium par dépôt sous vide:

6. Procédé selon l'une quelconque des revendications 1 à 5, selon lequel la bande métallique est préalablement revêtue d'une couche de zinc ou d'alliage de zinc présentant une épaisseur comprise entre 0,5 et 15 µm.

7. Procédé selon l'une ou l'autre des revendications 5 ou 6, selon lequel on dépose une couche de magnésium par dépôt sous vide en une épaisseur comprise entre 0,2 et 5 µm.

8. Procédé selon l'une quelconque des revendications 5 à 7, selon lequel on forme, lors du recuit statique de diffusion, une couche d'alliage de composition Zn₂Mg, comprenant éventuellement des composés Zn₁₁Mg₂.

9. Procédé selon l'une quelconque des revendications 1 à 8, selon lequel le revêtement de ladite bande métallique revêtue du métal ou de l'alliage métallique oxydable est oxydé en surface avant de subir ledit traitement statique de diffusion.

10. Procédé selon l'une quelconque des revendications 1 à 9, selon lequel ladite bobine de bande métallique est soumise à un traitement thermique de diffusion pendant une durée comprise entre 4 et 40 heures, avec un chauffage à une température inférieure à 200°C.

11. Procédé selon l'une quelconque des revendications 1 à 10, selon lequel la bande métallique est une bande d'acier.

12. Procédé selon la revendication 11, selon lequel la bande métallique est un acier à durcissement par cuisson (bake-hardening).

13. installation pour la fabrication d'une bande métallique revêtue par le procédé selon l'une quelconque des revendications 1 à 12, comprenant :
- un dispositif de galvanisation de ladite bande métallique nue, suivi par
- un dispositif de revêtement par dépôt sous vide, et
- un dispositif de traitement thermique statique sous atmosphère contrôlée.

14. Installation selon la revendication 13, dans laquelle ledit dispositif de galvanisation est un dispositif de galvanisation au trempé à chaud:

15. Installation selon la revendication 13, dans laquelle ledit dispositif de galvanisation est un dispositif de galvanisation par électrodéposition.

16. Installation selon la revendication 13, dans laquelle ledit dispositif de galvanisation est un dispositif de galvanisation par dépôt sous vide.

## Claims

1. Process for coating a metal strip, in which a layer of an oxidizable metal or an oxidizable metal alloy is vacuum-deposited on a metal strip precoated with zinc or with a zinc alloy, the coated metal strip is then coiled, and the wound coil undergoes a static diffusion treatment, in a non-oxidizing atmosphere, so as to obtain a strip having a coating that comprises, in the upper portion, a layer of an alloy formed by diffusion of the oxidizable metal or the oxidizable metal alloy in all or part of the zinc or zinc alloy layer.

2. Process according to Claim 1, in which the metal strip has been precoated with zinc or a zinc alloy by a hot-dip galvanizing process.

3. Process according to Claim 1, in which the metal strip has been precoated with zinc or a zinc alloy by an electroplating process.

4. Process according to Claim 1, in which the metal strip has been precoated with zinc or a zinc alloy by a vacuum deposition process.

5. Process according to any one of Claims 1 to 4, in which the zinc-coated or zinc-alloy-coated metal strip is coated with magnesium or a magnesium alloy by vacuum deposition.

6. Process according to any one of Claim 1 to 5, in which the metal strip is precoated with a zinc or zinc alloy layer having a thickness of between 0.5 and 15 µm.

7. Process according to either of Claims 5 and 6, in which a magnesium layer is deposited by vacuum deposition with a thickness of between 0.2 and 5 µm.

8. Process according to any one of Claims 5 and 7, in which a layer of an alloy with the composition Zn₂Mg, possibly comprising Zn₁₁Mg₂ compounds, is formed during the static diffusion annealing.

9. Process according to any one of Claims 1 to 8, in which the coating on said metal strip coated with the oxidizable metal or metal alloy is oxidized on the surface before undergoing said static diffusion treatment.

10. Process according to any one of Claims 1 to 9, in which said coil of metal strip is subjected to a diffusion heat treatment for a time of between 4 and 40 hours by heating it at a temperature below 200°C.

11. Process according to any one of Claims 1 to 10, in which the metal strip is a steel strip.

12. Process according to Claim 11, in which the metal strip is made of a bake-hardening steel.

13. Equipment for manufacturing a metal strip coated by the process according to any one of Claims 1 to 12, comprising:
- a device for galvanizing said bare metal strip; followed by
- a vacuum deposition coating device; and
- a static heat treatment device operating in a controlled atmosphere.

14. Equipment according to Claim 13, in which said galvanizing device is a hot-dip galvanizing device.

15. Equipment according to Claim 13, in which said galvanizing device is an electrogalvanizing device.

16. Equipment according to Claim 13, in which said galvanizing device is a vacuum deposition galvanizing device.

## Patentansprüche

1. Verfahren zum Beschichten eines Metallbandes, wobei eine Schicht aus einem oxidierbaren Metall oder einer oxidierbaren Metalllegierung im Vakuum auf ein Metallband aufgebracht wird, das zuvor mit Zink oder Zinklegierung beschichtet wurde, woraufhin das beschichtete Metallband aufgewickelt und die aufgewickelte Bandrolle unter einer nichtoxidierenden Atmosphäre einer statischen Behandlung mit Diffusionswirkung unterzogen wird, um ein Band zu erhalten, dessen Beschichtung in ihrem oberen Teil eine Legierung umfasst, welche sich bildet, indem das oxidierbare Metall oder die oxidierbare Metalllegierung in einen Teil oder die Gesamtheit der Schicht aus Zink oder Zinklegierung hineindiffundiert.

2. Verfahren nach Anspruch 1, wobei das Metallband zuvor mittels eines Feuerverzinkungsverfahrens mit Zink oder Zinklegierung beschichtet wurde.

3. Verfahren nach Anspruch 1, wobei das Metallband zuvor mittels eines elektrolytischen Abscheidungsverfahrens mit Zink oder Zinklegierung beschichtet wurde.

4. Verfahren nach Anspruch 1, wobei das Metallband zuvor mittels eines Vakuumabscheidungsverfahrens mit Zink oder Zinklegierung beschichtet wurde.

5. Verfahren nach einem beliebigen der Ansprüche 1 bis 4, wobei das Metallband, das mit Zink oder Zinklegierung beschichtet ist, mittels Vakuumabscheidung mit Magnesium oder Magnesiumlegierung beschichtet wird.

6. Verfahren nach einem beliebigen der Ansprüche 1 bis 5, wobei das Metallband zuvor mit einer Schicht aus Zink oder Zinklegierung beschichtet worden ist, die eine Dicke im Bereich von 0,5 bis 15 µm aufweist.

7. Verfahren nach einem der Ansprüche 5 oder 6, wobei mittels Vakuumabscheidung eine Magnesiumschicht in einer Dicke im Bereich von 0,2 bis 5 µm aufgebracht wird.

8. Verfahren nach einem beliebigen der Ansprüche 5 bis 7, wobei bei der statischen Nacherwärmung mit Diffusionswirkung eine Legierungsschicht mit der Zusammensetzung Zn₂Mg gebildet wird, die möglicherweise Zn₁₁Mg₂-Verbindungen umfasst.

9. Verfahren nach einem beliebigen der Ansprüche 1 bis 8, wobei die Beschichtung des Metallbandes, das mit dem oxidierbaren Metall oder mit der oxidierbaren Metalllegierung beschichtet ist, oberflächlich oxidiert wird, bevor es die statische Behandlung mit Diffusionswirkung erfährt.

10. Verfahren nach einem beliebigen der Ansprüche 1 bis 9, wobei die Metallbandrolle für einen Zeitraum im Bereich von 4 bis 40 Stunden einer Wärmebehandlung mit Diffusionswirkung unterzogen wird, mit einer Erwärmung auf eine Temperatur von weniger als 200 °C.

11. Verfahren nach einem beliebigen der Ansprüche 1 bis 10, wobei das Metallband ein Stahlband ist.

12. Verfahren nach Anspruch 11, wobei das Metallband ein Stahl mit Wärmehärtung (Bake-hardening) ist.

13. Anlage zur Herstellung eines Metallbandes, das mittels des Verfahrens nach einem beliebigen der Ansprüche 1 bis 12 beschichtet wird, umfassend:
- eine Vorrichtung zur Verzinkung des unbeschichteten Metallbands, gefolgt von
- einer Vorrichtung zur Beschichtung mittels Vakuumabscheidung und
- einer Vorrichtung zur statischen Wärmebehandlung unter kontrollierter Atmosphäre.

14. Anlage nach Anspruch 13, wobei es sich bei der Verzinkungsvorrichtung um eine Feuerverzinkungsvorrichtung handelt.

15. Anlage nach Anspruch 13, wobei es sich bei der Verzinkungsvorrichtung um eine Vorrichtung zur Verzinkung mittels elektrolytischer Abscheidung handelt.

16. Anlage nach Anspruch 13, wobei es sich bei der Verzinkungsvorrichtung um eine Vorrichtung zur Verzinkung mittels Vakuumabscheidung handelt.
